# EUROPEAN PATENT APPLICATION

(11) **EP 4 580 363 A1**
(43) Date of publication of application: **02.07.2025**
(21) Application number: 24220955.9
(22) Date of filing: 18.12.2024
(51) Int. Cl.: H10K 59/121, H10K 59/122, H10K 59/124, H10K 59/35, H10K 59/80

(54) **DISPLAY DEVICE**

(30) Priority: 29.12.2023 KR 20230197076
(71) Applicant: LG Display Co., Ltd., Seoul, 07336 (KR)
(72) Inventor: HONG, Seungpyo, 10845 Gyeonggi-do (KR); SIM, Yosup, 10845 Gyeonggi-do (KR)
(74) Representative: Ter Meer Steinmeister & Partner

(57) **Abstract**

A display device may include a substrate; transmissive areas spaced apart from each other; an area which includes sub-pixels; an over-coating layer which is disposed on the substrate and includes a base portion and a protrusion on the base portion; and an anode which is disposed in each sub-pixel and covers the base portion and a part of the protrusion. Each sub-pixel may include an emission area and an outer peripheral area which encloses the emission area. The outer peripheral area may include first outer peripheral areas opposite to adjacent other sub-pixels and second outer peripheral areas opposite to adjacent transmissive areas. Trenches may be disposed in the protrusion in the first outer peripheral areas. The anode may be disposed in the trenches in the first outer peripheral areas.

## Description

This application claims the benefit of and priority to Korean Patent Application No. 10-2023-0197076 filed on December 29, 2023.

### BACKGROUND

### 1. Technical Field

The disclosure relates to a display device, and more particularly to, for example, without limitation, a display device which improves a light extraction efficiency and minimizes an image distortion in a transmissive area.

### 2. Description of the Related Art

Currently, as it enters a full-scale information era, a field of a display device which visually expresses electrical information signals has been rapidly developed and studies are continuing to improve performances of various display devices such as those with a thin-thickness, a light weight, and low power consumption.

Among various display devices, a display device is a self-emitting display device so that a separate light source is not necessary, which is different from a liquid crystal display device. Therefore, the display device may be manufactured to have a light weight and a small thickness. Further, since the light emitting display device is driven at a low voltage, it is advantageous not only in terms of power consumption, but also in terms of color implementation, a response speed, a viewing angle, and a contrast ratio (CR). Therefore, it is expected to be utilized in various fields.

The description of the related art should not be assumed to be prior art merely because it is mentioned in or associated with this section. The description of the related art includes information that describes one or more aspects of the subject technology, and the description in this section does not limit the invention.

### SUMMARY

An aspect to be achieved by the disclosure is to provide a display device with high efficiency and low power consumption which is capable of improving the luminous efficiency of a light emitting diode using a side mirror type first electrode.

Another aspect to be achieved by the disclosure is to provide a display device which improves the luminous efficiency of a light emitting diode and minimizes degradation of the quality of a transmissive area.

Aspects of the disclosure are not limited to the above-mentioned aspects, and other aspects, which are not mentioned above, can be clearly understood by those skilled in the art from the disclosure.

The object is solved by the features of the independent claims. Preferred embodiments are given in the dependent claims.

According to one or more aspects of the disclosure, a display device includes a substrate; a plurality of transmissive areas; an area which includes a plurality of sub-pixels; an over-coating layer which is disposed on the substrate and includes a base portion and a protrusion on the base portion; and an anode which is disposed in each of the plurality of sub-pixels and covers the base portion and a part of the protrusion, wherein each of the plurality of sub-pixels includes an emission area and an outer peripheral area which encloses the emission area, the outer peripheral area includes a plurality of first outer peripheral areas opposite to adjacent other sub-pixels and a plurality of second outer peripheral areas opposite to adjacent transmissive areas, a plurality of trenches is disposed in the protrusion in the plurality of first outer peripheral areas, and the anode may be disposed in the plurality of trenches in the plurality of first outer peripheral areas.

According to one or more aspects of the disclosure, a display device includes: a substrate; a plurality of transmissive areas; an area which includes a plurality of sub-pixels; an over-coating layer which is disposed on the substrate and includes a base portion and a protrusion which is disposed on the base portion to expose a part of the base portion; and an anode which is disposed in each of the plurality of sub-pixels and covers the base portion and a part of the protrusion, wherein at each of the plurality of sub-pixels, the protrusion has an inclined side surface and a top surface which encloses the inclined side surface, the inclined side surface being adjacent to an area in which the base portion is exposed by the protrusion, the anode disposed on the top surface of the protrusion in each of the plurality of sub-pixels includes a trench pattern, and in one sub-pixel, the trench pattern may be disposed in a position opposite to another sub-pixel adjacent to the one sub-pixel.

According to one or more aspects of the disclosure, a display device includes: a transmissive area; an area; and a first sub-pixel and a second sub-pixel, both of which are disposed in the area, wherein: the first sub-pixel includes an emission area and a peripheral area having a first peripheral area and a second peripheral area; at the first sub-pixel, an anode is disposed in the emission area, the first peripheral area, and the second peripheral area; the second sub-pixel is adjacent to the first sub-pixel; and the anode includes a trench pattern disposed in the first peripheral area that is opposite to the second sub-pixel, and the trench pattern is not disposed in the second peripheral area that is opposite to the transmissive area.

In one or more embodiments, a top surface of the protrusion may be flat in the plurality of second outer peripheral areas.

In one or more embodiments, the anode is disposed to be flat on the top surface of the protrusion in the plurality of second outer peripheral areas.

In one or more embodiments, the plurality of sub-pixels may include a plurality of first sub-pixels, a plurality of second sub-pixels, and a plurality of third sub-pixels which are to emit different color light.

In one or more embodiments, the plurality of first sub-pixels may be disposed between the plurality of second sub-pixels and the plurality of third sub-pixels along a first direction; and the plurality of second sub-pixels and the plurality of third sub-pixels may be alternately disposed in a second direction which intersects the first direction.

In one or more embodiments, the display device may further comprise one or more line units which are disposed to transmit one or more signals to at least some of the plurality of sub-pixels.

In one or more embodiments, the plurality of transmissive areas may be disposed in a matrix; and any one of the plurality of sub-pixels or the one or more line units may be disposed between the plurality of transmissive areas.

In one or more embodiments, each of the plurality of first sub-pixels may be disposed between one transmissive area and another transmissive area adjacent thereto in a second direction.

In one or more embodiments, each of the plurality of second sub-pixels or each of the plurality of the third sub-pixels may be disposed between one transmissive area and another transmissive area adjacent thereto in a diagonal direction.

In one or more embodiments, each emission area of the plurality of second sub-pixels and the plurality of third sub-pixels may have a polygonal shape having a diagonal corner opposite to an adjacent transmissive area.

In one or more embodiments, one of the plurality of second outer peripheral areas may be disposed in a diagonal corner opposite to an adjacent transmissive area.

In one or more embodiments, a side surface of the protrusion at each of the plurality of sub-pixels may have an inclined surface.

In one or more embodiments, the anode may be disposed on a respective top surface of the base portion exposed by the protrusion, on a respective side surface of the protrusion, and on a part of a respective top surface of the protrusion.

In one or more embodiments, no trench may be disposed in the protrusion in the plurality of second outer peripheral areas opposite to the adjacent transmissive areas.

In one or more embodiments, the display device may further comprise one or more line units configured to transmit one or more signals.

In one or more embodiments, at least one of the plurality of trenches may be disposed at at least one location opposite to the one or more line units.

In one or more embodiments, the display device may further comprise a trench disposed in the outer peripheral area.

In one or more embodiments, the trench may be disposed at a location opposite to one or more line units.

In one or more embodiments, the one or more line units may be configured to transmit one or more signals.

In one or more embodiments, at least a portion of the one or more line units may be disposed in at least a region that is for being transmissive.

In one or more embodiments, the plurality of sub-pixels may include a plurality of first sub-pixels, a plurality of second sub-pixels, and a plurality of third sub-pixels which are to emit different color light.

In one or more embodiments, the plurality of first sub-pixels may be disposed between the plurality of second sub-pixels and the plurality of third sub-pixels along a first direction.

In one or more embodiments, the plurality of second sub-pixels and the plurality of third sub-pixels may be alternately disposed in a second direction which intersects the first direction.

In one or more embodiments, the display device may further comprise one or more line units which are disposed to transmit one or more signals to at least some of the plurality of sub-pixels.

In one or more embodiments, the plurality of transmissive areas may be disposed in a matrix; and any one of the plurality of sub-pixels or the one or more line units may be disposed between the plurality of transmissive areas.

In one or more embodiments, in the one sub-pixel, the trench pattern may be disposed in a position opposite to one of the one or more line units.

In one or more embodiments, one of the plurality of first sub-pixels may be disposed between one transmissive area and another transmissive area adjacent thereto in a second direction; and one of the plurality of second sub-pixels or one of the plurality of third sub-pixels may be disposed between one transmissive area and another transmissive area adjacent thereto in a diagonal direction.

In one or more embodiments, each emission area of one of the plurality of second sub-pixels and one of the plurality of third sub-pixels may have a polygonal shape having a diagonal corner opposite to an adjacent transmissive area; and a region, in which the trench pattern is not disposed, may be disposed in a diagonal corner opposite to an adjacent transmissive area.

In one or more embodiments, for the anode disposed on the top surface of the protrusion in the one sub-pixel: all trench patterns may be disposed at positions opposite to one or more sub-pixels adjacent to the one sub-pixel; and no trench pattern exists in a region that is not opposite to any sub-pixel adjacent to the one sub-pixel.

In one or more embodiments, in the one sub-pixel, at least one edge of the trench pattern may have a pointed shape, and the at least one edge may protrude toward the another sub-pixel adjacent to the one sub-pixel.

In one or more embodiments, the display device may further comprise one or more line units including a reference voltage line or a power line and configured to transmit one or more signals.

In one or more embodiments, the trench pattern in the one sub-pixel may be disposed at a location opposite to the one or more line units.

In one or more embodiments, the anode at the one sub-pixel may include a second trench pattern.

In one or more embodiments, the second trench pattern may be disposed at a location opposite to one or more line units.

In one or more embodiments, the one or more line units may be configured to transmit one or more signals; and at least a portion of the one or more line units may be disposed in at least a region that is for being transmissive.

In one or more embodiments, the display device may comprise a third sub-pixel adjacent to the first sub-pixel.

In one or more embodiments, the second sub-pixel relative to the first sub-pixel may be disposed along a first direction; the third sub-pixel relative to the first sub-pixel may be disposed along a second direction that is not parallel to the first direction; the anode may include a second trench pattern disposed in the first peripheral area that is opposite to the third sub-pixel; and a shape of the second trench pattern may be different from a shape of the trench pattern.

In one or more embodiments, the emission area may include a first emission area and a second emission area.

In one or more embodiments, the anode disposed in the first emission area may be flat.

In one or more embodiments, the anode disposed in the second emission area may be inclined.

In one or more embodiments, a first non-emission area may be located between the first emission area and the second emission area.

In one or more embodiments, the first non-emission area may surround the first emission area.

In one or more embodiments, the second emission area may surround the first non-emission area.

In one or more embodiments, the peripheral area may be a second non-emission area that surrounds the second emission area.

In one or more embodiments, the anode may include a plurality of trench patterns in the second non-emission area.

In one or more embodiments, the plurality of trench patterns may only partially surround the second emission area.

In one or more embodiments, the plurality of trench patterns may be opposite to a plurality of sub-pixels adjacent to the first sub-pixel.

In one or more embodiments, the plurality of trench patterns may include a first trench pattern, a second trench pattern adjacent to the first trench pattern, a third trench pattern adjacent to the second trench pattern, and a fourth trench pattern adjacent to the third trench pattern along the second non-emission area.

In one or more embodiments, a gap may exist in the second non-emission area between each pair of adjacent trench patterns among the plurality of trench patterns.

In one or more embodiments, a shape of each of the first and third trench patterns may be different from a shape of each of the second and fourth trench patterns.

In one or more embodiments, the anode disposed in the second emission area may be configured to reflect at least some of light emitted from an emission layer of the first sub-pixel; and the trench pattern disposed in the first peripheral area of the second non-emission area is configured to reflect at least some of light emitted from the emission layer and to scatter light.

In one or more embodiments, the display device may further comprise one or more line units configured to transmit one or more signals.

In one or more embodiments, the trench pattern may be disposed at a location opposite to the one or more line units.

In one or more embodiments, the anode may include a second trench pattern.

In one or more embodiments, the second trench pattern may disposed at a location opposite to one or more line units.

In one or more embodiments, the one or more line units may be configured to transmit one or more signals; and at least a portion of the one or more line units is disposed in at least a region that is for being transmissive.

Other detailed matters of the embodiments are included in the detailed description and the drawings.

According to one or more aspects of the disclosure, the light extraction efficiency of the light emitting display device may be improved using a side mirror type anode and power consumption may be improved.

According to one or more aspects of the disclosure, the light extraction efficiency of the light emitting diode is improved and light is not scattered in a position which is opposite to the transmissive area so that the image distortion in the transmissive area is minimized and a quality of the transmissive area may be improved.

The effects according to the disclosure are not limited to the contents described above, and other various effects are included in the disclosure.

Additional features, advantages, and aspects of the disclosure are set forth in part in the description that follows and in part will become apparent from the disclosure or may be learned by practice of the inventive concepts provided herein. Other features, advantages, and aspects of the disclosure may be realized and attained by the descriptions provided in the disclosure, or derivable therefrom, and the claims hereof as well as the drawings. It is intended that all such features, advantages, and aspects be included within this description, be within the scope of the disclosure, and be protected by the following claims. Nothing in this section should be taken as a limitation on those claims. Further aspects and advantages are discussed below in conjunction with embodiments of the disclosure.

It is to be understood that both the foregoing description and the following description of the disclosure are examples, and are intended to provide further explanation of the disclosure as claimed.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure, and together with the description serve to explain principles and s of the disclosure. In the drawings:
FIG. 1 is a plan view of a display device of an embodiment of the disclosure;
FIGS. 2A and 2B are examples of enlarged plan views of an area A of FIG. 1;
FIG. 3 is an example of an enlarged plan view of an area B of FIG. 2B;
FIG. 4 is an example of a cross-sectional view of a display device taken along C-C' of FIG. 3;
FIG. 5 is an example of a cross-sectional view of a display device taken along D-D' of FIG. 3; and
FIG. 6 is an example of a cross-sectional view of a display device taken along E-E' of FIG. 2B.

Throughout the drawings and the detailed description, unless otherwise described, the same drawing reference numerals should be understood to refer to the same elements, features, and structures. The sizes, lengths, and thicknesses of layers, regions and elements, and depiction thereof may be exaggerated for clarity, illustration, and/or convenience.

### DETAILED DESCRIPTION

Reference is now made in detail to embodiments of the disclosure, examples of which may be illustrated in the accompanying drawings. In the following description, when a detailed description of well-known methods, functions, structures or configurations may unnecessarily obscure aspects of the disclosure, the detailed description thereof may have been omitted for brevity. Further, repetitive descriptions may be omitted for brevity. The progression of processing steps and/or operations described is a non-limiting example.

The sequence of steps and/or operations is not limited to that set forth herein and may be changed to occur in an order that is different from an order described herein, with the exception of steps and/or operations necessarily occurring in a particular order. In one or more examples, two operations in succession may be performed substantially concurrently, or the two operations may be performed in a reverse order or in a different order depending on a function or operation involved.

Unless stated otherwise, like reference numerals may refer to like elements throughout even when they are shown in different drawings. Unless stated otherwise, the same reference numerals may be used to refer to the same or substantially the same elements throughout the specification and the drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

Advantages and features of the disclosure, and implementation methods thereof, are clarified through the embodiments described with reference to the accompanying drawings. The disclosure may, however, be embodied in different forms and should not be construed as limited to the embodiments set forth herein. Rather, these embodiments are examples and are provided so that this disclosure may be thorough and complete to assist those skilled in the art to understand the inventive concepts without limiting the protected scope of the disclosure.

Shapes, dimensions (e.g., sizes, lengths, widths, heights, thicknesses, locations, radii, diameters, and areas), proportions, ratios, angles, numbers, the number of elements, and the like disclosed herein, including those illustrated in the drawings, are merely examples, and thus, the disclosure is not limited to the illustrated details. It is, however, noted that the relative dimensions of the components illustrated in the drawings are part of the disclosure.

When the term "comprise," "have," "include," "contain," "constitute," "made of," "formed of," "composed of," or the like is used with respect to one or more elements (e.g., layers, films, components, anodes, trenches, parts, regions, areas, portions, steps, operations, and/or the like), one or more other elements may be added unless a term such as "only" or the like is used. The terms used in the disclosure are merely used in order to describe particular embodiments, and are not intended to limit the scope of the disclosure. The terms of a singular form may include plural forms unless the context clearly indicates otherwise. For example, an element may be one or more elements. An element may include a plurality of elements. The word "exemplary" is used to mean serving as an example or illustration. Embodiments are example embodiments. Aspects are example aspects. In one or more implementations, "embodiments," "examples," "aspects," and the like should not be construed to be preferred or advantageous over other implementations. An embodiment, an example, an example embodiment, an aspect, or the like may refer to one or more embodiments, one or more examples, one or more embodiments, one or more aspects, or the like, unless stated otherwise. Further, the term "may" encompasses all the meanings of the term "can."

In one or more aspects, unless explicitly stated otherwise, an element, feature, or corresponding information (e.g., a level, range, dimension, size, or the like) is construed to include an error or tolerance range even where no explicit description of such an error or tolerance range is provided. An error or tolerance range may be caused by various factors (e.g., process factors, internal or external impact, noise, or the like). In interpreting a numerical value, the value is interpreted as including an error range unless explicitly stated otherwise.

When a positional relationship between two elements (e.g., layers, films, components, anodes, trenches, parts, regions, areas, portions, and/or the like) are described using any of the terms such as "on," "on a top of," "upon," "on top of," "over," "under," "above," "upper," "at an upper portion," "at a upper side," "below," "lower," "at a lower portion," "at a lower side," "beneath," "near," "close to," "adjacent to," "beside," "next to," "at or on a side of," and/or the like indicating a position or location, one or more other elements may be located between the two elements unless a more limiting term, such as "immediate(ly)," "direct(ly)," or "close(ly)," is used. For example, when an element and another element are described using any of the foregoing terms, this description should be construed as including a case in which the elements contact each other directly as well as a case in which one or more additional elements are disposed or interposed therebetween. Furthermore, the spatially relative terms such as the foregoing terms as well as other terms such as "front," "rear," "back," "left," "right," "top," "bottom," "upper," "lower," "downward," "upward," "up," "down," "column," "row," "vertical," "horizontal," "diagonal," and the like refer to an arbitrary frame of reference. For example, these terms may be used for an example understanding of a relative relationship between elements, including any correlation as shown in the drawings. However, embodiments of the disclosure are not limited thereby or thereto. The spatially relative terms are to be understood as terms including different orientations of the elements in use or in operation in addition to the orientation depicted in the drawings or described herein. For example, where a lower element or an element positioned under another element is overturned, then the element may be termed as an upper element or an element positioned above another element. Thus, for example, the term "under" or "beneath" may encompass, in meaning, the term "above" or "over." An example term "below" or the like, can include all directions, including directions of "below," "above" and diagonal directions. Likewise, an example term "above," "on" or the like can include all directions, including directions of "above," "on," "below" and diagonal directions.

In describing a temporal relationship, when the temporal order is described as, for example, "after," "following," "subsequent," "next," "before," "preceding," "prior to," or the like, a case that is not consecutive or not sequential may be included and thus one or more other events may occur therebetween, unless a more limiting term, such as "just," "immediate(ly)," or "direct(ly)," is used.

It is understood that, although the terms "first," "second," and the like may be used herein to describe various elements (e.g., layers, films, components, anodes, trenches, parts, regions, areas, portions, steps, operations, and/or the like), these elements should not be limited by these terms, for example, to any particular order, precedence, or number of elements. These terms are used only to distinguish one element from another. For example, a first element may denote a second element, and, similarly, a second element may denote a first element, without departing from the scope of the disclosure. Furthermore, the first element, the second element, and the like may be arbitrarily named according to the convenience of those skilled in the art without departing from the scope of the disclosure. For clarity, the functions or structures of these elements (e.g., the first element, the second element, and the like) are not limited by ordinal numbers or the names in front of the elements. Further, a first element may include one or more first elements. Similarly, a second element or the like may include one or more second elements or the like.

In describing elements of the disclosure, the terms "first," "second," "A," "B," "(a)," "(b)," or the like may be used. These terms are intended to identify the corresponding element(s) from the other element(s), and these are not used to define the essence, basis, order, or number of the elements.

The expression that an element (e.g., layer, film, component, anode, trench, part, region, area, portion, or the like) "is engaged" with another element may be understood, for example, as that the element may be either directly or indirectly engaged with the another element. The term "is engaged" or similar expressions may refer to a term such as "encloses," "surrounds," "is in contact," "covers," "overlaps," "crosses," "intersects," "is connected," "is coupled," "is attached," "is adhered," "is combined," "is linked," "is provided," "is disposed," "interacts," or the like. The engagement may involve one or more intervening elements disposed or interposed between the element and the another element, unless otherwise specified. Further, the element may be engaged at least partially or entirely (or completely) with the another element, unless otherwise specified. Further, the element may be included in at least one of two or more elements that are engaged with each other. Similarly, the another element may be included in at least one of two or more elements that are engaged with each other. When the element is engaged with the another element, at least a portion of the element may be engaged with at least a portion of the another element. The term "with another element" or similar expressions may be understood as "another element," or "with, to, in, or on another element," as appropriate by the context. Similarly, the term "with each other" may be understood as "each other," or "with, to, or on each other," as appropriate by the context.

The phrase "through" may be understood, for example, to be at least partially through or entirely through.

The terms such as a "line" or "direction" should not be interpreted only based on a geometrical relationship in which the respective lines or directions are parallel, perpendicular, diagonal, or slanted with respect to each other, and may be meant as lines or directions having wider directivities within the range within which the components of the disclosure may operate functionally. For example, the terms "first direction," "second direction," "row direction," "column direction," "diagonal direction," and the like should not be interpreted only based on a geometrical relationship in which the respective directions are parallel, perpendicular, diagonal, or slanted with respect to each other, and may be meant as directions having wider directivities within the range within which the components of the disclosure may operate functionally.

The term "at least one" should be understood as including any and all combinations of one or more of the associated listed items. For example, each of the phrases "at least one of a first item, a second item, or a third item" and "at least one of a first item, a second item, and a third item" may represent (i) a combination of items provided by two or more of the first item, the second item, and the third item or (ii) only one of the first item, the second item, or the third item. Further, at least one of a plurality of elements can represent (i) one element of the plurality of elements, (ii) some elements of the plurality of elements, or (iii) all elements of the plurality of elements. Further, "at least some," "at least some portions," "at least some parts," "at least a portion," "at least one or more portions," "at least a part," "at least one or more parts," "at least some elements," "one or more," or the like of a plurality of elements can represent (i) one element of the plurality of elements, (ii) a portion (or a part) of the plurality of elements, (iii) one or more portions (or parts) of the plurality of elements, (iv) multiple elements of the plurality of elements, or (v) all of the plurality of elements. Moreover, "at least some," "at least some portions," "at least some parts," "at least a portion," "at least one or more portions," "at least a part," "at least one or more parts," or the like of an element can represent (i) a portion (or a part) of the element, (ii) one or more portions (or parts) of the element, or (iii) the element, or all portions of the element.

The expression of a first element, a second elements "and/or" a third element should be understood as one of the first, second and third elements or as any or all combinations of the first, second and third elements. By way of example, A, B and/or C may refer to only A; only B; only C; any of A, B, and C (e.g., A, B, or C); some combination of A, B, and C (e.g., A and B; A and C; or B and C); or all of A, B, and C. Furthermore, an expression "A/B" may be understood as A and/or B. For example, an expression "A/B" may refer to only A; only B; A or B; or A and B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two. Furthermore, when an element is referred to as being "between" at least two elements, the element may be the only element between the at least two elements, or one or more intervening elements may also be present.

In one or more aspects, the phrases "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

In one or more aspects, the phrases "one or more among" and "one or more of" may be used interchangeably simply for convenience unless stated otherwise.

The term "or" means "inclusive or" rather than "exclusive or." That is, unless otherwise stated or clear from the context, the expression that "x uses a or b" means any one of natural inclusive permutations. For example, "a or b" may mean "a," "b," or "a and b." For example, "a, b or c" may mean "a," "b," "c," "a and b," "b and c," "a and c," or "a, b and c."

A phrase "substantially the same" or "nearly the same" may indicate a degree of being considered as being equivalent to each other taking into account minute differences due to errors in the manufacturing process.

Features of various embodiments of the disclosure may be partially or entirely coupled to or combined with each other, may be technically associated with each other, and may be variously operated, linked or driven together in various ways. Embodiments of the disclosure may be implemented or carried out independently of each other or may be implemented or carried out together in a co-dependent or related relationship. In one or more aspects, the components of each apparatus and deviceof various embodiments of the disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein.

The terms used herein have been selected as being general in the related technical field; however, there may be other terms depending on the development and/or change of technology, convention, preference of technicians, and so on. Therefore, the terms used herein should not be understood as limiting technical ideas, but should be understood as examples of the terms for describing example embodiments.

Further, in a specific case, a term may be arbitrarily selected by an applicant, and in this case, the detailed meaning thereof is described herein. Therefore, the terms used herein should be understood based on not only the name of the terms, but also the meaning of the terms and the content hereof.

In the following description, various example embodiments of the disclosure are described in more detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the disclosure are not limited to a scale, dimension, size, and thickness illustrated in the drawings.

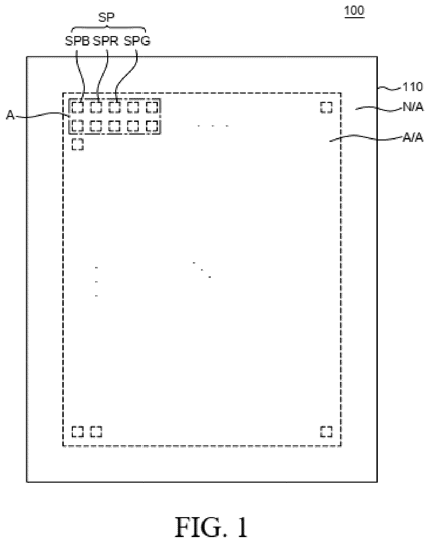

FIG. 1 is a plan view of a display device of an example embodiment of the disclosure. Referring to FIG. 1, the display device 100 includes a substrate 110. The display device 100 may be implemented as a top emission type display device, but is not limited thereto.

The substrate 110 is a substrate which supports and protects a plurality of components of the display device 100. The substrate 110 may be formed of a glass or a plastic material having flexibility. When the substrate 110 is formed of a plastic material, for example, the substrate may be formed of polyimide (PI), but it is not limited thereto.

The substrate 110 includes an active area A/A and a non-active area N/A.

The active area A/A is an area in which an image is displayed in the display device 100 and a display element and various driving elements for driving the display element are disposed in the active area A/A. For example, the display element may be configured by a light emitting diode including a first electrode, an organic layer, and a second electrode. Further, various driving elements for driving the display element, such as transistors, capacitors, or wiring lines may be disposed in the active area A/A.

A plurality of sub-pixels SP may be included in the active area A/A. The sub-pixel SP is a minimum unit which configures a screen and each of the plurality of sub-pixels SP may include a light emitting diode and a driving circuit. The plurality of sub-pixels SP may emit light having different wavelengths. The plurality of sub-pixels may include first to third sub-pixels which emit different color light. For example, the plurality of sub-pixels SP may include a red sub-pixel SPR which may be a first sub-pixel, a green sub-pixel SPG which may be a second sub-pixel, and a blue sub-pixel SPB which may be a third sub-pixel. Further, the plurality of sub-pixels SP may further include a white sub-pixel.

The driving circuit of the sub-pixel SP is a circuit for controlling the driving of the light emitting diode. For example, the driving circuit may be configured to include a transistor and a capacitor, but is not limited thereto.

The non-active area N/A is an area adjacent to the active area A/A. The non-active area N/A is an area where no image is displayed and various components for driving the plurality of sub-pixels SP disposed in the active area A/A may be disposed in the non-active area N/A. For example, a driving circuit or a driving integrated circuit (IC) which supplies signals for driving the plurality of sub-pixels SP and a flexible film may be disposed. In some examples, a driving circuit or a driving IC may include a plurality of driving circuits or a plurality of driving ICs.

The non-active area N/A may be an area which encloses the active area A/A as illustrated in FIG. 1 or extends from the active area A/A. However, the disclosure is not limited thereto.

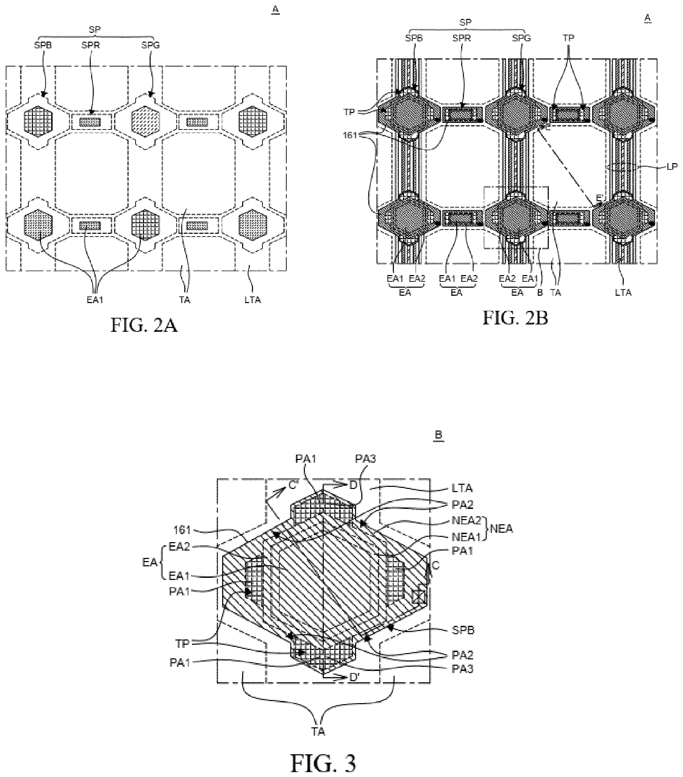

FIGS. 2A and 2B are examples of enlarged plan views of an area A of FIG. 1. For the convenience of description, in FIG. 2A, among various components of the display device 100, only a plurality of transmissive areas TA, a less-transmissive area LTA, a plurality of sub-pixels SP, and a plurality of emission areas EA are illustrated. Further, in FIG. 2B, only a plurality of line units LP, a plurality of first electrodes 161, and a plurality of trench patterns TP are further illustrated in addition to those shown in FIG. 2A. In some examples, a less-transmissive area LTA may be referred to as an area and vice versa.

In one or more aspects, a less-transmissive area LTA may be an area where light is less transmitted than a transmissive area TA. In an example, light is less transmissive in a less-transmissive area LTA compared to each of the plurality of transmissive areas TA or to the plurality of transmissive areas TA. In one or more examples, a less-transmissive area LTA may include one or more less-transmissive areas LTA, or a plurality of less-transmissive areas LTA.

Referring to FIGS. 2A and 2B, in the active area A/A, the transmissive area TA and the less-transmissive area LTA are disposed. A plurality of transmissive areas TA is disposed to be spaced apart from each other. In this example, the plurality of transmissive areas TA which is spaced apart from each other is disposed in a matrix. In an example, the less-transmissive area LTA may be disposed so as to enclose or surround the plurality of transmissive areas TA. In the less-transmissive area LTA, a plurality of sub-pixels SP and a plurality of line units LP which transmits one or more signals to the plurality of sub-pixels SP are disposed. Therefore, in an example, the less-transmissive area LTA in which the plurality of sub-pixels SP and the plurality of line units LP are disposed may have a low transmittance due to the configuration of the plurality of sub-pixels SP and the plurality of line units LP and may be a substantially opaque area. Further, the plurality of transmissive areas TA may be substantially transparent areas in which the plurality of sub-pixels SP and the plurality of line units LP are not disposed.

In an example, the less-transmissive area LTA may include a first area having elements (e.g., a substrate, dielectric layers, cathodes, anodes, light-emitting layers, electrodes and/or line units) formed of a transparent material(s), and a second area having elements (e.g., transistors and/or light emitting diodes) formed of a less transparent material(s). In this example, the second area may be less transmissive than the first area. In this example, the first area may be less transmissive than a transmissive area TA, or may be substantially as transmissive as a transmissive area TA. In some aspects, the first area may be viewed as a transmissive area. In some aspects, when the first area is substantially as transmissive as a transmissive area TA, the first area may be viewed as a transmissive area.

In each of the plurality of sub-pixels SP, a first emission area EA1 which emits light by a light emitting diode and a driving element is defined. The first emission area EA1 is an area in which light is substantially emitted from a respective one of the plurality of sub-pixels. For example, the first emission area EA1 is defined as an area in which a first electrode of the light emitting diode is exposed by (or from) a bank, but it is not limited thereto.

The plurality of line units LP transmits signals to the driving elements and the light emitting diodes of the plurality of sub-pixels SP and may overlap at least a part of the plurality of sub-pixels SP. The plurality of line units LP includes wiring lines which supply signals from a driving IC(s) of the non-active area N/A to the plurality of sub-pixels SP of the active area A/A. For example, the plurality of line units LP includes a reference voltage line, a low potential power line, and a high potential power line extending in a column direction in the active area A/A, among various wiring lines of the display device 100, but is not limited thereto.

Referring to FIG. 2B, the plurality of line units LP overlaps a green sub-pixel SPG and a blue sub-pixel SPB, among the plurality of sub-pixels SP. The green sub-pixel SPG and the blue sub-pixel SPB may be alternately disposed in the column direction, for example, in a second direction, along the line unit LP extending in the column direction. Further, sub-pixels SP which emit different color light are disposed in a line unit LP in a different column adjacent to the line unit LP of each column, in a row direction, for example, a first direction.

In this example, the red sub-pixel SPR is disposed between the green sub-pixel SPG and the blue sub-pixel SPB disposed in the same row. That is, the red sub-pixel SPR does not overlap the line unit LP extending in the column direction, but may be disposed between the line units LP and may be connected to the line unit LP by a connection line extending in the row direction, but is not limited thereto.

Referring to FIGS. 2A and 2B, any one of the plurality of sub-pixels or the plurality of line units LP is disposed between the plurality of transmissive areas TA. The red sub-pixel SPR is disposed between one transmissive area TA and another transmissive area TA adjacent thereto in the column direction. The line unit LP is disposed between one transmissive area TA and another transmissive area TA adjacent thereto in the row direction. The green sub-pixels SPG or the blue sub-pixels SPB are alternately disposed between one transmissive area TA and another transmissive area TA adjacent thereto in the diagonal direction. That is, each of the plurality of transmissive areas TA is disposed to be enclosed or surrounded by any one of the plurality of sub-pixels or the plurality of line units LP.

When light meets a slit, superposition and cancellation occur to cause periodic diffraction. Further, in the transparent display device, the transmissive area serves as a slit through which light is transmitted. In this example, as the transmissive area is divided more, the periodicity is increased so that the diffraction may become more severe. Therefore, in the display device in which each of the plurality of sub-pixels is enclosed by a plurality of divided transmissive areas, the diffraction is more distinct. Accordingly, in the transparent display device, there is a problem in that the more distinct the diffraction of light, the less the sharpness or visibility of the transparent display device.

Therefore, in the display device 100 of the embodiment, each of the plurality of transmissive areas TA is enclosed by a plurality of sub-pixels SP and a plurality of line units LP. Therefore, the degree to which the transmissive area TA is divided is minimized and the diffraction of light in the transparent display device 100 may be minimized. As a result, the sharpness and the visibility of the display device may be improved.

In the meantime, referring to FIG. 2B, in one sub-pixel SP, a trench pattern TP is disposed in a position opposite to (or facing) another adjacent sub-pixel SP. That is, in one sub-pixel SP, the trench pattern TP is not disposed in a position opposite to (or facing) the transmissive area TA. Referring to FIG. 2B, in the red sub-pixel SPR, the trench pattern TP is disposed in a position opposite to the green sub-pixel SPG and the blue sub-pixel SPB adjacent thereto in the row direction. That is, in the red sub-pixel SPR, the trench pattern TP is disposed on both ends in the row direction, and is thus disposed in a total of two portions. In the green sub-pixel SPG, the trench pattern TP is disposed in a position opposite to the red sub-pixel SPR adjacent thereto in the row direction and a position opposite to the blue sub-pixel SPB adjacent thereto in the column direction. That is, in the green sub-pixel SPG, the trench pattern TP is disposed on both ends in the row direction and the column direction, and is thus disposed in a total of four portions. In the blue sub-pixel SPB, the trench pattern TP is disposed in a position opposite to the red sub-pixel SPR adjacent thereto in the row direction and a position opposite to the green sub-pixel SPG adjacent thereto in the column direction. That is, in the blue sub-pixel SPB, the trench pattern TP is disposed on both ends in the row direction and the column direction, and is thus disposed in a total of four portions.

For example, as illustrated in FIGS. 2A and 2B, when a planar shape of the emission area EA (or the first emission area EA1) of each of the green sub-pixel SPG and the blue sub-pixel SPB is a polygonal shape having diagonal corners opposite to the transmissive area TA, the trench pattern TP is not disposed in a portion corresponding to the diagonal corner. However, it is not limited thereto.

Therefore, in FIG. 2B, for the convenience of illustration, in the first electrode 161, the trench pattern TP is illustrated with a hatching different from the other portions of the first electrode 161. A portion of the first electrode 161 in which the trench pattern TP is disposed is formed of the same material as the other portions of the first electrode 161, and the disclosure is not limited thereto.

In the meantime, the trench pattern TP will be described in detail with reference to FIGS. 3 to 6.

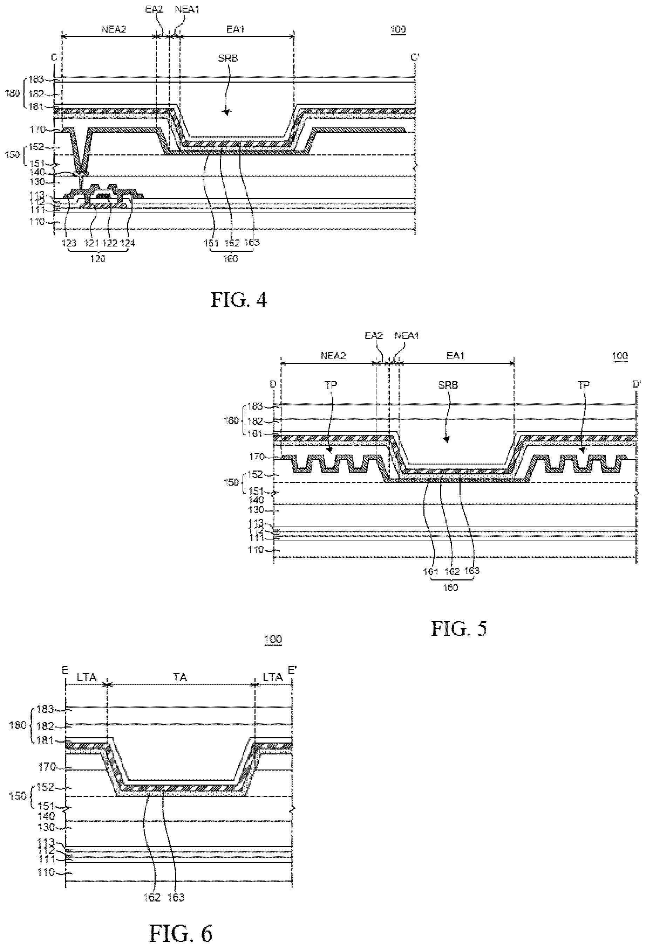

FIG. 3 is an example of an enlarged plan view of an area B of FIG. 2B. FIG. 4 is an example of a cross-sectional view of a display device taken along C-C' of FIG. 3. FIG. 5 is an example of a cross-sectional view of a display device taken along D-D' of FIG. 3. FIG. 6 is an example of a cross-sectional view of a display device taken along E-E' of FIG. 2B. FIG. 4 is an example of a cross-sectional view of a portion of one sub-pixel SP in which the trench pattern TP is not disposed, and FIG. 5 is example of a cross-sectional view of a portion of one sub-pixel SP in which the trench pattern TP is disposed. FIG. 6 is an example of a cross-sectional view of one transmissive area TA.

Referring to FIGS. 3 to 6, the display device 100 includes a substrate 110, a transistor 120, a first over-coating layer 130, an auxiliary electrode 140, a second over-coating layer 150, a light emitting diode 160, a bank 170, and an encapsulation unit 180.

Referring to FIGS. 4 and 5, in each of the plurality of sub-pixels SP of the display device 100, the substrate 110, a buffer layer 111, a gate insulating layer 112, an interlayer insulating layer 113, a transistor 120, a first over-coating layer 130, an auxiliary electrode 140, a second over-coating layer 150, a first electrode 161, an organic layer 162, a second electrode 163, a bank 170, and an encapsulation unit 180 are disposed.

The buffer layer 111 is disposed on the substrate 110. The buffer layer 111 may serve to improve adhesiveness between layers formed on the buffer layer 111 and the substrate 110 and block (or reduce) alkali components leaking from the substrate 110. The buffer layer 111 may be formed as a single layer of silicon nitride (SiNx) or silicon oxide (SiOx) or a multiple layer of silicon nitride (SiNx) and silicon oxide (SiOx), but it is not limited thereto. The buffer layer 111 is not an essential component and may be omitted based on a type or a material of the substrate 110 and a structure and a type of the transistor 120.

The transistor 120 is disposed on the buffer layer 111 in each of the plurality of sub-pixels SP. The transistor 120 may be used as a driving element which drives the light emitting diode 160 of the active area A/A. The transistor 120 includes an active layer 121, a gate electrode 122, a source electrode 123, and a drain electrode 124. The transistor 120 illustrated in FIG. 4 is a driving transistor and is a top gate type thin film transistor in which the gate electrode 122 is disposed on the active layer 121. However, it is not limited thereto and the transistor 120 may be implemented as a bottom gate type transistor.

The active layer 121 is disposed on the buffer layer 111. The active layer 121 is an area in which a channel is formed when the transistor 120 is driven. The active layer 121 may be formed of an oxide semiconductor or amorphous silicon (a-Si), polycrystalline silicon (poly-Si), or an organic semiconductor.

The gate insulating layer 112 is disposed on the active layer 121. The gate insulating layer 112 is a layer for electrically insulating the gate electrode 122 from the active layer 121 and may be formed of an insulating material. For example, the gate insulating layer 112 may be formed as a single layer of silicon nitride (SiNx) or silicon oxide (SiOx) which is an inorganic material or a multiple layer of silicon nitride (SiNx) or silicon oxide (SiOx), but it is not limited thereto.

In the gate insulating layer 112, a contact hole through which the source electrode 123 and the drain electrode 124 are in contact with a source region and a drain region of the active layer 121, respectively, is formed. The gate insulating layer 112 may be formed on the entire surface of the substrate 110 as illustrated in FIG. 4, or patterned to have the same width as the gate electrode 122, but is not limited thereto.

The gate electrode 122 is disposed on the gate insulating layer 112. The gate electrode 122 is disposed on the gate insulating layer 112 so as to overlap a channel region of the active layer 121. The gate electrode 122 may be any one of various metal materials, for example, any one of molybdenum (Mo), aluminum (Al), chrome (Cr), gold (Au), titanium (Ti), nickel (Ni), neodymium (Nd), and copper (Cu) or an alloy of two or more of them, or a multiple layer thereof, but it is not limited thereto.

The interlayer insulating layer 113 is disposed on the gate electrode 122. The interlayer insulating layer 113 may be formed as a single layer of silicon nitride (SiNx) or silicon oxide (SiOx) which is an inorganic material or a multiple layer of silicon nitride (SiNx) or silicon oxide (SiOx), but it is not limited thereto. In the interlayer insulating layer 113, a contact hole through which the source electrode 123 and the drain electrode 124 are in contact with the source region and the drain region of the active layer 121, respectively, is formed.

The source electrode 123 and the drain electrode 124 are disposed on the interlayer insulating layer 113. The source electrode 123 and the drain electrode 124 are disposed on the same layer to be spaced apart from each other. The source electrode 123 and the drain electrode 124 are electrically connected to the active layer 121 through the contact holes of the gate insulating layer 112 and the interlayer insulating layer 113. The source electrode 123 and the drain electrode 124 may be any one of various metal materials such as molybdenum (Mo), aluminum (Al), chrome (Cr), gold (Au), titanium (Ti), nickel (Ni), neodymium (Nd), and copper (Cu) or an alloy of two or more of them, or a multiple layer thereof, but the disclosure is not limited thereto.

In FIG. 4, only a driving transistor, among various transistors 120 included in the display device 100, is illustrated, but other transistors such as a switching transistor may also be disposed.

The first over-coating layer 130 is disposed on the interlayer insulating layer 113 and the transistor 120. The first over-coating layer 130 is an insulating layer which protects the transistor 120 and planarizes an upper portion of the transistor 120. A contact hole which exposes the source electrode 123 of the transistor 120 is formed on the first over-coating layer 130. Even though in FIG. 4, it is illustrated that a contact hole which exposes the source electrode 123 is formed on the first over-coating layer 130, it is not limited thereto. For example, a contact hole which exposes the drain electrode 124 may be formed on the first over-coating layer 130.

The first over-coating layer 130 may be formed of one of acrylic-based resin, epoxy resin, phenol resin, polyamide-based resin, polyimide-based resin, unsaturated polyester-based resin, polyphenylene-based resin, polyphenylene sulfide-based resin, benzocyclobutene, and photoresist, but is not limited thereto.

In the meantime, a passivation layer which covers the interlayer insulating layer 113 and the transistor 120 may be further disposed below the first over-coating layer 130. The passivation layer may be formed as a single layer of silicon nitride (SiNx) or silicon oxide (SiOx) or a multiple layer of silicon nitride (SiNx) or silicon oxide (SiOx), but it is not limited thereto.

The auxiliary electrode 140 is disposed on the first over-coating layer 130. The auxiliary electrode 140 may serve to electrically connect the transistor 120 and the light emitting diode 160. The auxiliary electrode 140 is electrically connected to the source electrode 123 of the transistor 120 through a contact hole formed in the first over-coating layer 130. The auxiliary electrode 140 may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof.

The second over-coating layer 150 is disposed on the first over-coating layer 130. The second over-coating layer 150 is an insulating layer for planarizing upper portions of the first over-coating layer 130 and the auxiliary electrode 140. A contact hole which exposes the auxiliary electrode 140 is formed on the second over-coating layer 150.

The second over-coating layer 150 may be formed of one of acrylic-based resin, epoxy resin, phenol resin, polyamide-based resin, polyimide-based resin, unsaturated polyester-based resin, polyphenylene-based resin, polyphenylene sulfide-based resin, benzocyclobutene, and photoresist, but is not limited thereto.

The second over-coating layer 150 includes a base portion 151 and a protrusion 152. As illustrated in FIGS. 4 and 5, the base portion 151 and the protrusion 152 may be integrally formed. For example, the base portion 151 and the protrusion 152 are formed of the same material to be simultaneously formed by the same process, for example, by a mask process, but are not limited thereto.

The base portion 151 is disposed on the first over-coating layer 130. A top surface of the base portion 151 has a surface parallel to the substrate 110. Therefore, a step generated due to components disposed therebelow may be planarized by the base portion 151.

The protrusion 152 is disposed on the base portion 151. The protrusion 152 is integrally formed with the base portion 151 to protrude from the base portion 151. However, it is not limited thereto and the protrusion 152 may be formed separately from the base portion 151. That, after forming the base portion 151 with a flat top surface, the protrusion may be separately formed on the top surface of the base portion 151. A Top surface of the protrusion 152 may be smaller than its bottom surface, but is not limited thereto.

At each sub-pixel, the protrusion 152 includes a top surface and a side surface. The top surface of the protrusion 152 is a surface located on an uppermost portion of the protrusion 152 and may be a surface substantially parallel to the base portion 151 or the substrate 110. That is, the top surface of the protrusion 152 is flat. The side surface of the protrusion 152 may be a surface which connects the top surface of the protrusion 152 and the base portion 151. The side surface of the protrusion 152 may be inclined toward the base portion 151 from the top surface.

The light emitting diode 160 is disposed on the second over-coating layer 150 in each of the plurality of sub-pixels SP.

The light emitting diode 160 includes a first electrode 161 which is electrically connected to the source electrode 123 of the transistor 120, an organic layer 162 disposed on the first electrode 161, and a second electrode 163 formed on the organic layer 162.

The first electrode 161 is disposed so as to correspond to each of the plurality of sub-pixels SP. The first electrode 161 is disposed so as to cover the base portion 151 and a part of the protrusion 152. In this example, a first electrode 161 of a sub-pixel covers the base portion 151 at or in the sub-pixel and a part of the protrusion 152 at or in the sub-pixel. The first electrode 161 may be disposed along a shape of the base portion 151 and the protrusion 152 of the planarization layer at the sub-pixel. Specifically, the first electrode 161 may be disposed on the top surface of the base portion 151 in which the protrusion 152 is not disposed and side surfaces of the protrusion 152. That is, the first electrode 161 at the sub-pixel is disposed along the shape of the base portion 151 and the protrusion 152 at the sub-pixel. Further, the first electrode 161 may be formed in a partial area of the top surface of the protrusion 152 at the sub-pixel. That is, the first electrode 161 may be disposed to be flat on the top surfaces of the protrusion 152 at the sub-pixel.

The first electrode 161 may be an anode of the light emitting diode 160. The first electrode 161 is electrically connected to the auxiliary electrode 140 through the contact hole which is formed on the second over-coating layer 150. The first electrode 161 may be electrically connected to the source electrode 123 of the transistor 120 through the auxiliary electrode 140. However, the first electrode 161 may be configured to be electrically connected to the drain electrode 124 of the transistor 120 depending on a type of the transistor 120 and a design manner of the driving circuit.

Each of the plurality of sub-pixels SP includes an emission area EA and an outer peripheral area which encloses the emission area EA. In this example, the emission area EA and the outer peripheral area may be defined by each part of the first electrode 161.

For example, the emission area EA includes a first emission area EA1 and a second emission area EA2 which encloses the first emission area EA1. The non-emission area NEA may include a first non-emission area NEA1 between the first emission area EA1 and the second emission area EA2 and a second non-emission area NEA2 which encloses the second emission area EA2. In this example, the outer peripheral area may be a second non-emission area NEA2.

The first emission area EA1 may correspond to an area in which a top surface of the first electrode 161 is exposed by the bank 170. That is, the first emission area EA1 may be an area in which some of light emitted from the organic layer 162 is extracted to the outside of the display device 100 via the organic layer 162 and the second electrode 163.

The first emission area EA1 is enclosed by the first non-emission area NEA1. The first non-emission area NEA1 may be an area in which some of light emitted from the organic layer 162 reaches the bank 170 so that the light is not extracted to the outside of the display device 100. The first non-emission area NEA1 may correspond to an area in which the first electrode 161 disposed on the top surface of the base portion 151 is covered by the bank 125.

When the display device 100 is on, the first non-emission area NEA1 is in a black state or has a luminance lower than those of the first emission area EA1 and the second emission area EA2 due to light incident from at least one light emitting unit, of the first emission area EA1 and the second emission area EA2.

The first non-emission area NEA1 may be enclosed by the second emission area EA2. The second emission area EA2 of a sub-pixel may correspond to an area in which the first electrode 161 of the sub-pixel is disposed on the inclined surfaces of the protrusion 152 at the sub-pixel. That is, the second emission area EA2 may be an area in which some of light emitted from the organic layer 162 is reflected by the first electrode 161 disposed on the inclined surfaces of the protrusion 152 to be extracted to the outside of the display device 100.

The second emission area EA2 may be enclosed by the second non-emission area NEA2. The second non-emission area NEA2 at a sub-pixel may correspond to an area in which the first electrode 161 at the sub-pixel is disposed on the top surface of the protrusion 152 at the sub-pixel. Therefore, the second non-emission area NEA2 is defined as an outer peripheral area, but is not limited thereto.

The second non-emission area NEA2 may be an area in which components for driving the emission area EA are disposed. For example, in the first electrode 161, a contact hole through which the first electrode 161 and the transistor 120 are connected may be disposed in the second non-emission area NEA2, but is not limited thereto.

When the display device 100 is on, the second non-emission area NEA2 is in a black state or has a luminance lower than those of the first emission area EA1 and the second emission area EA2 due to light incident from at least one light emitting unit, of the first emission area EA1 and the second emission area EA2. However, the disclosure is not limited thereto.

In the second non-emission area NEA2, the trench pattern TP is disposed. The trench pattern TP is disposed along a plurality of trenches disposed on the top surface of the protrusion 152 being disposed with a pattern having a plurality of trench shapes. The trench pattern TP may improve a light extraction efficiency and a front surface efficiency by reflecting light emitted from the organic layer 162. In the meantime, even though in FIG. 5, it is illustrated that the trench pattern TP has a trapezoidal cross-section, the cross-sectional shape of the trench pattern TP may be various convex shapes, for example, may be one of a triangular shape, a circular shape, and a trapezoidal shape, but it is not limited thereto.

In the second non-emission area NEA2 of each of the plurality of sub-pixels SP, in one sub-pixel SP, the trench pattern TP is disposed in a position opposite to another sub-pixel SP adjacent thereto. For example, when in the second non-emission area NEA2, in one sub-pixel SP, an area opposite to another adjacent sub-pixel SP is a first outer peripheral area and an area opposite to the transmissive area TA is a second outer peripheral area, the trench pattern TP is disposed in the first outer peripheral area. That is, in the second non-emission area NEA2 of each of the plurality of sub-pixels SP, the trench pattern TP may not be disposed in a position opposite to the transmissive area TA, but it is not limited thereto.

In the meantime, as the trench pattern TP is disposed, a surface area of the first electrode 161 is increased and a length of a component disposed on the first electrode 161, for example, the organic layer 162 may be increased. Therefore, when the display device 100 is driven, the trench pattern TP minimizes a problem of a lateral leakage current (LLC) that a current is leaked to an adjacent sub-pixel which shares an organic layer to cause the adjacent sub-pixel to emit light, but it is not limited thereto.

In this example, even though in FIGS. 4 and 5, the first electrode 161 is illustrated as a single layer, the first electrode 161 may be configured as a multilayer. For example, the first electrode 161 may include a reflective layer which reflects light emitted from the organic layer 162 toward the second electrode 163 and a transparent conductive layer which supplies holes to the organic layer 162.

The reflective layer is disposed on the second over-coating layer 150 to reflect light emitted from the light emitting diode 160 upwardly. The light generated in the organic layer 162 of the light emitting diode 160 may be emitted not only upwardly, but also laterally. The light which is laterally emitted is directed to the inside of the display device 100 or trapped in the display device 100 due to the total reflection, or further travels to the inside of the display device 100 and then disappears. Therefore, the reflective layer is disposed below the organic layer 162 to cover side portions of the protrusion 152 to change a traveling direction of the light which is directed to a side portion of the organic layer 162 to a front surface direction.

The reflective layer may be formed of a metal material such as aluminum (Al), silver (Ag), copper (Cu), and a magnesium-silver alloy (Mg : Ag), but is not limited thereto.

The transparent conductive layer is disposed on the reflective layer. The transparent conductive layer may be formed of a conductive material having a high work function to supply holes to the organic layer 162. For example, the transparent conductive layer may be formed of transparent conductive oxide such as indium tin oxide (ITO), indium zinc oxide (IZO), indium tin zinc oxide (ITZO), zinc oxide (ZnO), and tin oxide (TO), but is not limited thereto.

The bank 170 is disposed on the second over-coating layer 150 and the first electrode 161. The bank 170 is an insulating layer which separates adjacent sub-pixels SP. The bank 170 is disposed so as to open a part of the first electrode 161 to form an open area and forms a non-open area which covers a part of the first electrode 161 to define the emission area EA and the non-emission area. In this example, the bank 170 is disposed so as to open a part of the first electrode 161 to form an open area corresponding to the first emission area EA1, and the bank 170 forms a non-open area which covers a part of the first electrode 161. This non-open area can form the first non-emission area NEA1, the second emission area EA2, and the second non-emission area NEA2.

The bank 170 may be formed of an inorganic material. For example, the bank 170 may be formed of a single layer of silicon nitride (SiNx) or silicon oxide (SiOx) or a multiple layer of silicon nitride (SiNx) and silicon oxide (SiOx). However, it is not limited thereto and the bank 170 may be formed of an organic material.

The organic layer 162 is disposed on the first electrode 161 and the bank 170. For example, the organic layer 162 is disposed on the first electrode 161 in the first emission area EA1 and is disposed on the bank 170 in the second emission area EA2 and the non-emission area NEA, which includes the first and second non-emission areas NEA1 and NEA2. The organic layer 162 may be disposed along the shapes of the first electrode 161 and the bank 170. The organic layer 162 includes an emission layer and a common layer.

The emission layer is an organic layer which emits light with a specific color. Different emission layers may be disposed in the plurality of sub-pixels SP or the same emission layer may be disposed in all of the plurality of sub-pixels SP. For example, when different emission layers are disposed in the plurality of sub-pixels SP, a red emission layer is disposed in a red sub-pixel SPR, a green emission layer is disposed in the green sub-pixel SPG, and a blue emission layer is disposed in the blue sub-pixel SPB. When the same emission layer is disposed in all of the plurality of sub-pixels SP, light from the emission layer may be converted to various color light through a separate color conversion layer and a color filter. In some examples, a color filter may be disposed on an encapsulation unit 180 or on one or more layers thereof. Further, the color filter may be disposed within (or may overlap) an emission area (e.g., EA or EA1).

The common layer is an organic layer which is disposed to improve luminous efficiency of the emission layer. The common layer may be formed as the same layer over the plurality of sub-pixels SP. That is, the common layers of the plurality of sub-pixels SP are simultaneously formed with the same material by the same process. The common layer may include a hole injection layer, a hole transport layer, an electron transport layer, an electron injection layer, and a charge generation layer, but is not limited thereto.

In the meantime, the organic layer 162 may be configured by laminating a plurality of light emitting units which includes emission layers and is configured to emit light. For example, each light emitting unit includes a hole injection layer, a hole transport layer, an emission layer, an electron transport layer, and an electron injection layer and a charge generation layer which supplies charges to the plurality of light emitting units is disposed between the adjacent light emitting units. Therefore, in the organic layer 162, light in which light emitted from the plurality of light emitting units is mixed may be emitted, but is not limited thereto.

The second electrode 163 is disposed on the organic layer 162. The second electrode 163 may be disposed along the shape of the organic layer 162. The second electrode 163 supplies electrons to the organic layer 162 so that the second electrode may be formed of a conductive material having a low work function. The second electrode 163 may be a cathode of the light emitting diode 160. The second electrode 163 may be formed of a transparent conductive material such as indium tin oxide (ITO) or indium zinc oxide (IZO), or a metal alloy such as magnesium silver (MgAg) or a ytterbium (Yb) alloy and may further include a metal doping layer, but is not limited thereto. In the meantime, even though it is not illustrated in the drawing, the second electrode 163 is electrically connected to a low potential power line to be supplied with a low potential power signal.

An encapsulation unit 180 may be formed on the light emitting diode 160 to protect the light emitting diode 160 which is vulnerable to moisture so as not to be exposed to the moisture. The encapsulation unit 180 may block the oxygen and moisture which penetrate into the light emitting display device 100 from the outside. For example, when the light emitting display device 100 is exposed to the moisture or oxygen, a pixel shrink phenomenon that the emission area is shrunk occurs or a dead pixel in the emission area is generated. Therefore, the encapsulation unit 180 blocks the oxygen and moisture to protect the light emitting display device 100. For example, the encapsulation unit 180 may have a structure in which inorganic layers and organic layers are alternately laminated, but is not limited thereto.

Referring to FIGS. 4 to 6, the encapsulation unit 180 includes a first encapsulation layer 181, a foreign material cover layer 182, and a second encapsulation layer 183.

The first encapsulation layer 181 is disposed on the second electrode 163 to suppress the permeation of the moisture or oxygen. The first encapsulation layer 181 may be formed of an inorganic material such as silicon nitride (SiNx), silicon oxynitride (SiNxOy), or aluminum oxide (AlyOz), but is not limited thereto. The first encapsulation layer 181 may be formed of a material having a refractive index higher than that of the foreign material cover layer 182.

The foreign material cover layer 182 is disposed on the first encapsulation layer 181 to planarize the surface. Further, the foreign material cover layer 182 may cover foreign materials or particles which may be generated during a manufacturing process. The foreign material cover layer 182 may be formed of an organic material, such as silicon oxy carbon (SiOxCz), acryl or epoxy-based resin, but is not limited thereto.

The second encapsulation layer 183 is disposed on the foreign material cover layer 182 and suppresses the permeation of the moisture or oxygen, like the first encapsulation layer 181. The second encapsulation layer 183 may be formed of an inorganic material such as silicon nitride (SiNx), silicon oxynitride (SiNxOy), silicon oxide (SiOx), or aluminum oxide (AlyOz), but is not limited thereto. The second encapsulation layer 183 may be formed of the same material as the first encapsulation layer 181 or formed of a different material.

Referring to FIG. 6, in the transmissive area TA of the display device 100, a substrate 110, a buffer layer 111, a gate insulating layer 112, an interlayer insulating layer 113, a first over-coating layer 130, a second over-coating layer 150, an organic layer 162, a second electrode 163, a bank 170, and an encapsulation unit 180 are disposed. That is, in the transmissive area TA, the first electrode 161 may not be disposed. In the meantime, in FIG. 6, it is illustrated that the organic layer 162 and the second electrode 163 of the light emitting diode 160 are also disposed in the transmissive area TA. However, the organic layer 162 or the second electrode 163 may not be disposed in the transmissive area TA or at least a part of them may be disposed to be open in the transmissive area TA, but the disclosure is not limited thereto.

In the meantime, in the transmissive area TA, the bank 170 may be open so as to correspond to the transmissive area TA. Therefore, the transmissive area TA may be defined as an area in which the transistor 120 and the first electrode 161 are not disposed and the second over-coating layer 150 is exposed by the bank 170, but it is not limited thereto.

In the display device using a first electrode formed on an over-coating layer having a flat top surface, light which is emitted at a low emission angle, among light emitted from the organic layer is trapped in the light emitting display device due to total reflection loss or light waveguide loss to cause the degradation of the luminous efficiency. Therefore, an over-coating layer having a protrusion is used and the first electrode is disposed on the inclined side surfaces of the protrusion to reflect light emitted from the organic layer and extract to the outside of the display device, thereby improving the light extraction efficiency of the light emitting diode.

However, a light path of some of light reflected by the first electrode disposed on the inclined surfaces of the protrusion may be changed by the bank. Accordingly, there may be a problem in that the light with a changed path is guided to an area between the first electrode and the second electrode which overlaps the protrusion to be trapped in the display device again. Therefore, the trench pattern is disposed in the first electrode disposed on the flat top surface of the protrusion so that light guided to the area between the first electrode and the second electrode which overlaps the protrusion is scattered to extract light to the outside of the display device.

However, in the transparent display device in which a light transmitting area which is a substantially transparent area is disposed, the light scattered by the trench pattern is scattered to a transmissive area adjacent to the trench pattern. When light emitted from the light emitting diode is scattered to the transmissive area, the image incident to the transmissive area is visible to be brighter and a haze is generated, and an image may be distorted. Therefore, there is an additional problem of degradation of a quality of the transparent display device.

Accordingly, in the display device 100 of the example embodiment of the disclosure, the trench pattern TP is disposed in a position of one sub-pixel SP opposite to another adjacent sub-pixel SP, in the outer peripheral area which encloses the emission area EA to improve a quality of a transparent display device 100.

Specifically, in the display device 100 of the example embodiment of the disclosure, the first electrode 161 is disposed on a side surface and a top surface of the protrusion 152 to reflect light emitted from the organic layer 162 and extract the light to the outside of the display device. Further, the trench pattern TP is disposed in the first electrode 161 disposed on the top surface of the protrusion 152 to scatter light guided to an area between the first electrode 161 and the second electrode 163 by the bank 170, among light reflected by the first electrode 161. Therefore, light which may be trapped in the display device 100 is extracted to the outside of the display device 100 to improve the light extraction efficiency. In this example, the trench pattern TP is disposed in a position of one sub-pixel SP opposite to another adjacent sub-pixel SP. That is, the trench pattern TP in one sub-pixel SP is not disposed in a position opposite to the transmissive area TA and light emitted from the organic layer 162 is not scattered in the position opposite to the transmissive area TA. Accordingly, the trench pattern TP is configured to improve the light extraction efficiency of the light emitting diode 160 and so as not to scatter light in a position opposite to the transmissive area TA. Accordingly, the problem in that an image incident to the transmissive area TA is visible to be brighter to be distorted due to the sub-pixel SP adjacent to the transmissive area TA may be minimized. Accordingly, in the display device 100of the example embodiment of the disclosure, the trench pattern TP is disposed in a position opposite to another adjacent sub-pixel SP, in the outer peripheral area which encloses the emission area EA in one sub-pixel SP. Therefore, the problem in that an image incident to the transmissive area TA is visible to be brighter to be distorted due to the sub-pixel SP adjacent to the transmissive area TA may be minimized and a quality of a transparent display device 100 may be improved.

Various examples and aspects of the disclosure are described below. These are provided as examples, and do not limit the scope of the disclosure.

In connection with FIGS. 1 to 6, in one or more aspects, the display device 100 may be, may be included in, or may include, a foldable device. A foldable device may refer to, or may be, a foldable display device, a rollable device, a bendable device, a flexible device, a stretchable device, a curved device, a sliding device, or a variable device, and vice versa. The display device 100of one or more aspects of the disclosure may be, or may be included in, a mobile terminal (e.g., a smart phone, a video phone, a smart watch, a watch phone, a wearable device, a tablet, an electronic notebook, a notebook computer, a netbook computer, an e-book, a portable multimedia player (PMP), a personal digital assistant (PDA), an MPEG-1 Audio Layer 3 (MP3) player, a mobile medical device, a laptop, or the like), a desktop personal computer (PC), a workstation, a navigation device, a car navigation device, a vehicle display device, a vehicle apparatus, a theater apparatus, a theater display device, a television, a wallpaper device, a signage device, a gaming device, a monitor, a camera, a sensor, a camcorder, or a home appliance, or the like. The display device 100of one or more aspects of the disclosure are not limited to the foregoing example devices. The display device 100of one or more aspects of the disclosure may be made in various types, sizes, and shapes that are configured to display information and/or images.

In connection with FIGS. 1 to 6, in one or more aspects, when the display device 100 is a foldable device, a foldable area may be formed around a folding axis. In an example, the foldable area may overlap a portion of the active area A/A and/or a portion of the non-active area N/A. The foldable area may be an area that is folded with a predefined curvature when the foldable device is folded in at least one scheme among inner folding and outer folding. An area other than the foldable area may be a non-foldable area. A foldable area may include one or more foldable areas. Moreover, when the display device 100 is the foldable device, the display device may further include a hinge structure for folding a display panel or the like, and a casing for supporting and accommodating the display panel or the like. In one or more examples, when the display device 100 is the foldable device, the substrate of the display device may be a multilayer substrate, and the substrate may be flexible.

In connection with FIGS. 1 and 4 to 6, in one or more aspects, the substrate 110 of the display device 100 may serve to support and protect constituent elements of the display device 100 that are disposed above the substrate 110. The substrate 110 is a component for supporting various constituent elements included in the display device 100 and may be made of one or more insulating materials. The substrate 110 may be a multilayer substrate (e.g., a triple-layer substrate), including, for example, a first substrate, a second substrate, and an inorganic insulation layer. The inorganic insulation layer may be disposed between the first substrate and the second substrate. The substrate, being multilayer, can minimize moisture penetration from the outside. In another example, the substrate 110 may be disposed as a single layer.

The first substrate may have rigidity and flexibility. Among the components of the substrate 110, the first substrate may be configured to substantially support the constituent elements of the display device 100. For example, the first substrate may be a flexible substrate made of polyimide (PI). However, the disclosure is not limited thereto.

The inorganic insulation layer may be disposed on an entire surface of the first substrate. The inorganic insulation layer may be made of an inorganic insulating material. For example, the inorganic insulation layer may be configured as a single layer or multilayer made of silicon nitride (SiNx) or silicon oxide (SiOx). However, the disclosure is not limited thereto.

The second substrate may be disposed on the inorganic insulation layer. The second substrate may have rigidity and flexibility. Among the components of the substrate 110, the second substrate, together with the first substrate, may be configured to substantially support the constituent elements of the display device 100. For example, the second substrate may be a flexible substrate made of polyimide (PI). However, the disclosure is not limited thereto.

According to some example embodiments, the active area A/A of the display device 100 may include a normal active area (although not specifically designated in the figures) and an optical area (although not specifically designated in the figures). In an example, the normal active area may be the active area A/A excluding the optical area. In an example, the normal active area may be an area disposed within the active area A/A but outside the optical area. An area may include one or more areas. A normal active area may include one or more normal active areas. An optical area may include one or more optical areas. When multiple optical areas are provided, a normal active area may be the active area A/A excluding all optical areas. When no optical area is provided, a normal active area may be the active area A/A.

According to the some example embodiments, the display device 100 may include an optical electronic device (not shown). The optical electronic device may be an electronic component that is provided and installed separately from a display panel and positioned under the display panel (side opposite to the viewing surface). An optical electronic device may include one or more optical electronic devices. In an example, the display panel may include the components shown in any of FIGS. 4 to 6.

Light may enter the front surface (viewing surface) of the display panel and pass through the display panel to an optical electronic device positioned under the display panel (opposite to the viewing surface). For example, the light passing through the display panel may include visible light, infrared light, ultrasonic light, ultraviolet light, and/or the like.

The optical electronic device may be a device that receives the light transmitted through the display panel and performs a predetermined function of the received light. For example, the optical electronic device may include a capture device (e.g., a camera, a camera lens, or an image sensor) and/or a detection sensor (e.g., a proximity sensor and/or an illuminance sensor). For example, the detection sensor may be an infrared sensor. A sensor may be capable of detecting an object or a human body by receiving light.

In an example, the optical area may overlap an optical electronic device. In an example, the optical area may overlap at least a portion or an entirety of an optical electronic device. In an example, at least a portion or an entirety of the optical area may overlap an optical electronic device.

According to the some example embodiments, the optical area may have both an image display structure (e.g., sub-pixels including light emitting diodes 160) and a light transmission structure (e.g., one or more light transmissive areas). In other words, since the optical area is a partial area of the active area A/A, emission areas of sub-pixels (e.g., emissions areas EA of the light emitting diodes 160, or first emission areas EA1 and second emission areas EA2) for displaying images may be disposed in the optical area. In an example, a light transmission structure may be used to transmit light to the optical electronic device. In another example, when an optical electronic device is absent, the light transmission structure may be used to transmit light (either toward the back of the display panel or toward the front of the display panel). In an example, the image display structure may include a plurality of light emitting diodes 160 (or an array thereof, rows thereof, or columns thereof). In an example, the light transmission structure may include a plurality of light transmissive areas (or an array thereof, rows thereof, or columns thereof). In an example, the light emitting diodes 160 may be disposed between the light transmissive areas. In an example, an array of the light emitting diodes 160 and an array of the light transmissive areas may be interposed. In an example, a light emitting diode 160 may be adjacent to a corresponding light transmissive area. In an example, the light emitting diodes 160 may be disposed between a normal active area and one or more light transmissive areas. A light transmissive area may be referred to as a transmissive area TA, and vice versa.

In an example, the area A of FIG. 1 may be within a normal active area. In another example, the area A of FIG. 1 may be within an optical area. In yet another example, the area A of FIG. 1 may be in part in a normal active area and in part in an optical area.

According to some example embodiments, a light transmission structure may be configured in one of several different ways. A light transmission structure may be (i) a structure that includes a substrate formed of a transparent material(s); (ii) a structure with one or more dielectric layers formed of a transparent material(s); or (iii) a structure with at least some of the following: one or more dielectric layers as well as one or more metal layers, semiconducting layers, conductive layers, organic layers, and/or electrodes, each of which is formed of a transparent material(s). Therefore, a light transmission structure can be formed of a transparent material(s) that permit light to pass through. A light transmission structure may include one or more light transmission structures. Similarly, in some example embodiments, a light transmissive area may be configured in one of several different ways. A light transmissive area may be (i) an area that includes a substrate formed of a transparent material(s); (ii) an area with one or more dielectric layers formed of a transparent material(s); or (iii) an area with at least some of the following: one or more dielectric layers as well as one or more metal layers, semiconducting layers, conductive layers, organic layers, and/or electrodes, each of which is formed of a transparent material(s).

An optical electronic device may be a device that requires light reception, but is positioned behind (below, opposite to the viewing surface) the display panel to receive the light transmitted through the display panel. In one or more examples, the optical electronic device is not exposed on the front surface (viewing surface) of the display panel. Therefore, when the user looks at the front surface of the display device, the optical electronic device is not visible to the user.

When the optical electronic device is a camera, the camera may be a front camera that is positioned behind (below) the display panel but captures forward of the display panel. Accordingly, the user may take a photograph through the camera invisible to the viewing surface while viewing the viewing surface of the display panel.

In some example embodiments, the normal active area and the optical area included in the active area A/A are areas that may display images, but in another example, the normal active area may be an area that does not require a light transmission structure to be formed, and the optical area may be an area that includes a light transmission structure.

In some example embodiments, the optical area may have a transmittance (e.g., a transmittance per unit area) higher than or equal to a certain level, and the normal active area may have no light transmittance or a lower transmittance (e.g., a lower transmittance per unit area) that is less than the certain level.

In some example embodiments, the optical area (or an image display structure therein) may include some of the elements shown in FIG. 4 (e.g., the light emitting diode, some or all of the insulating layers, and/or some of the other elements). However, the optical area and the normal active area of the some embodiments may have different resolutions, sub-pixel placement structures, numbers of sub-pixels per unit area, electrode structures, line structures, electrode placement structures, and/or line placement structures.

For example, the number of sub-pixels per unit area in an optical area may be different from the number of sub-pixels per unit area in the normal active area, or the size of each sub-pixel (i.e., the size of the emission area) disposed in the optical area may be different from the size of a corresponding sub-pixel (i.e., the size of the emission area) disposed in the normal active area. In another example, the number of sub-pixels per unit area in an optical area may be the same as the number of sub-pixels per unit area in the normal active area, or the size of each sub-pixel (i.e., the size of the emission area) disposed in the optical area may be the same as the size of a corresponding sub-pixel (i.e., the size of the emission area) disposed in the normal active area.

In an example, the number of sub-pixels per unit area in an optical area may be smaller than the number of sub-pixels per unit area in the normal active area. In other words, the resolution of an optical area may be lower than the resolution of the normal active area. Here, the number of sub-pixels per unit area may be equivalent to resolution, or pixel density, or pixel integration degree. For example, the unit for the number of sub-pixels per unit area may be pixels per inch (PPI), which represents the number of pixels in one inch. In the foregoing example, the size of each sub-pixel (i.e., the size of the emission area) disposed in the optical area may be the same as the size of a corresponding sub-pixel (i.e., the size of the emission area) disposed in the normal active area.

In another example, the size of each sub-pixel (i.e., the size of the emission area) disposed in the optical area may be larger than the size of a corresponding sub-pixel (i.e., the size of the emission area) disposed in the normal active area.

In yet another example, the number of sub-pixels per unit area of the optical area may be larger than the number of sub-pixels per unit area of the normal active area.

In yet another example, the number of sub-pixels (or emission areas) per unit area of the optical area is identical or similar to the number of sub-pixels (or emission areas) per unit area of the normal active area, and the size of each sub-pixel (i.e., the size of the emission area) disposed in the optical area may be smaller than the size of a corresponding sub-pixel (i.e., the size of the emission area) disposed in the normal active area.

An optical area may have various shapes, such as a circle, an ellipse, a quadrangle, a hexagon, or an octagon. Furthermore, an image display structure and a light transmission structure within the optical area may have various shapes.

In the display device of some embodiments, if the optical electronic device that is not exposed to the outside and is hidden in a lower portion of the display panel is a camera, the display device of the some embodiments may be referred to as a display to which under display camera (UDC) technology has been utilized.

According to some embodiments, the display device does not require a notch or a camera hole for camera exposure to be formed in the display panel, thereby preventing a reduction in the active area A/A. Thus, as there is no need to form a notch or a camera hole for exposure of the camera in the display panel, the size of the bezel area may be reduced, and design restrictions may be freed, thereby increasing the degree of freedom in design. In an example, a notch or a camera hole may be a hollow space or a void lacking solid materials, metals or dielectric layers.

According to some embodiments, although an optical electronic device is positioned to be hidden behind the display panel, the optical electronic device can function as intended, such as receiving light properly and performing its predetermined functions in a normal manner.

Further, according to some embodiments, although an optical electronic device is positioned to be hidden behind the display panel and is positioned to overlap the active area A/A, the optical area overlapping the optical electronic device in the active area A/A can display images. However, when the optical area is designed as a transmissive area (or a transmittable area), the image display characteristics in the optical area may differ from the image display characteristics in the normal active area.

According to some embodiments, the normal active area and the optical area (and the components therein) described herein may be utilized and implemented in the display device illustrated with reference to FIGS. 1 to 6.

The light transmission structure described above of some embodiments does not require a notch or a camera hole. However, in another example, a light transmissions structure may include a notch or a camera hole.

Various examples and aspects of the disclosure are described further below. These are provided as examples, and do not limit the scope of the disclosure.

In one or more examples, a transparent material may be, or may include, a light-transmissive material. In some examples, a transparent material may include, or may be, a semi-transparent material.

In one or more examples, one or more trenches may be, or may include, at least one of one or more concave portions, one or more convex portions, one or more curved-in portions, one or more curved-out portions, one or more indented portions, one or more recessed portions, one or more depressed portions, one or more bent portions, one or more protruding portions, one or more raised portions, one or more projecting portions, one or more grooves, or the like, or some combination of the foregoing.

In one or more examples, one or more trench patterns may be, or may include, one or more patterns having one or more concave portions, one or more convex portions, one or more curved-in portions, one or more curved-out portions, one or more indented portions, one or more recessed portions, one or more depressed portions, one or more bent portions, one or more protruding portions, one or more raised portions, one or more projecting portions, one or more grooves, or the like, or some combination of the foregoing.

In one or more examples, an outer peripheral area may be or may include the second non-emission area NEA2. In this example, the outer peripheral area may include a plurality of first outer peripheral areas PA1 opposite to adjacent other sub-pixels and a plurality of second outer peripheral areas PA2 opposite to adjacent transmissive areas TA. In one or more examples, a trench pattern TP is disposed in a first outer peripheral area PA1, and a trench pattern TP is not disposed (or is missing) in a second outer peripheral area PA2.

In one or more examples, a peripheral area may include the outer peripheral area or a portion thereof. The peripheral area may include a plurality of first peripheral areas and a plurality of second peripheral areas. A first peripheral area may include a first outer peripheral area PA1 or a portion thereof, and a second peripheral area may include a second outer peripheral area PA2 or a portion thereof.

In one or more examples, a phrase that an element is opposite to another element can represent that the element faces the another element.

In one or more examples, a less-transmissive area LTA is not required to completely block transmission of light; however, a less-transmissive area LTA is configured to have a lower transmittance than a transmissive area TA.

In one or more examples, a non-emission area NEA is not required to completely block emission of light; however, a non-emission area NEA is configured to emit less light than an emission area EA.

In one or more examples, a first non-emission area NEA1 completely encloses or surrounds a first emission area EA1, a second emission area EA2 completely encloses or surrounds the first non-emission area NEA1, and a second non-emission area NEA2 completely encloses or surrounds the second emission area EA2. In one or more examples, an anode disposed in a first non-emission area NEA1 completely encloses or surrounds the anode disposed in a first emission area EA1, the anode disposed in a second emission area EA2 completely encloses or surrounds the anode disposed in the first non-emission area NEA1, and the anode disposed in a second non-emission area NEA2 completely encloses or surrounds the anode disposed in the second emission area EA2.

In some examples, a first non-emission area NEA1 may enclose or surround at least a part of a first emission area EA1 without completely enclosing or surrounding the first emission area EA1; a second emission area EA2 may enclose or surround at least a part of the first non-emission area NEA1 without completely enclosing or surrounding the first non-emission area NEA1; and a second non-emission area NEA2 may enclose or surround at least a part of the second emission area EA2 without completely enclosing or surrounding the second emission area EA2. In some examples, an anode disposed in a first non-emission area NEA1 may enclose or surround at least a part of the anode disposed in a first emission area EA1 without completely enclosing or surrounding the anode disposed in the first emission area EA1; the anode disposed in a second emission area EA2 may enclose or surround at least a part of the anode disposed in the first non-emission area NEA1 without completely enclosing or surrounding the anode disposed in the first non-emission area NEA1; and the anode disposed in a second non-emission area NEA2 may enclose or surround at least a part of the anode disposed in the second emission area EA2 without completely enclosing or surrounding the anode disposed in the second emission area EA2.

Although the embodiments of the disclosure have been described in detail with reference to the accompanying drawings, the disclosure is not limited thereto and may be embodied in many different forms without departing from the technical concepts of the disclosure. Therefore, the embodiments of the disclosure are provided for illustrative purposes only but not intended to limit the technical concepts of the disclosure. The scope of the technical concepts of the disclosure is not limited thereto. Therefore, it should be understood that the above-described embodiments are illustrative in all aspects and do not limit the disclosure. The protective scope of the disclosure should be construed based on the following claims, and all the technical concepts in the equivalent scope thereof should be construed as falling within the scope of the disclosure.

## Claims

1. A display device, comprising:
a substrate (110);
a plurality of transmissive areas (TA);
an area (A/A) which includes a plurality of sub-pixels (SP);
an over-coating layer (150) which is disposed on the substrate (110) and includes a base portion (151) and a protrusion (152) on the base portion (151); and
an anode (161) disposed in each of the plurality of sub-pixels (SP) and covers the base portion (151) and a part of the protrusion (152), wherein
each of the plurality of sub-pixels (SP) includes an emission area (EA) and an outer peripheral area which encloses the emission area (EA);
the outer peripheral area includes a plurality of first outer peripheral areas (PA1) opposite to adjacent other sub-pixels (SP) and a plurality of second outer peripheral areas (PA2) opposite to adjacent transmissive areas (TA);
a plurality of trenches (TP) is disposed in the protrusion (152) in the plurality of first outer peripheral areas (PA1); and
the anode (161) is disposed in the plurality of trenches (TP) in the plurality of first outer peripheral areas (PA1).

2. The display device of claim 1, wherein a top surface of the protrusion (152) is flat in the plurality of second outer peripheral areas; and the anode (161) is flat on the top surface of the protrusion (152) in the plurality of second outer peripheral areas.

3. The display device of claim 1 or 2, wherein the plurality of sub-pixels (SP) includes a plurality of first sub-pixels (SPR), a plurality of second sub-pixels (SPB), and a plurality of third sub-pixels (SPG) which are to emit different color light, preferably
the plurality of first sub-pixels (SPR) is disposed between the plurality of second sub-pixels (SPB) and the plurality of third sub-pixels (SPG) along a first direction; and
the plurality of second sub-pixels (SPB) and the plurality of third sub-pixels (SPB) are alternately disposed in a second direction which intersects the first direction.

4. The display device of any one of the preceding claims, further comprising: one or more line units (LP) which are disposed to transmit one or more signals to at least some of the plurality of sub-pixels (SP), preferably
the plurality of transmissive areas (TA) is disposed in a matrix; and
any one of the plurality of sub-pixels (SP) or the one or more line units (LP) is disposed between the plurality of transmissive areas (TA).

5. The display device of claim 3 or 4, wherein:
each of the plurality of first sub-pixels (SPR) is disposed between one transmissive area (TA) and another transmissive area (TA) adjacent thereto in a second direction; and
each of the plurality of second sub-pixels (SPB) or each of the plurality of the third sub-pixels (SPG) is disposed between one transmissive area (TA) and another transmissive area (TA) adjacent thereto in a diagonal direction.

6. The display device of claim 3, 4 or 5, wherein each emission area (EA) of the plurality of second sub-pixels (SPB) and the plurality of third sub-pixels (SPG) has a polygonal shape having a diagonal corner opposite to an adjacent transmissive area (TA); and one of the plurality of second outer peripheral areas (PA2) is disposed in a diagonal corner opposite to an adjacent transmissive area (TA).

7. The display device of any one of the preceding claims, wherein a side surface of the protrusion (152) at each of the plurality of sub-pixels (SP) has an inclined surface; and the anode (161) is disposed on a respective top surface of the base portion (151) exposed by the protrusion (152), on a respective side surface of the protrusion (152), and on a part of a respective top surface of the protrusion (152).

8. The display device of any one of the preceding claims, wherein no trench (TP) is disposed in the protrusion (152) in the plurality of second outer peripheral areas (PA2) opposite to the adjacent transmissive areas (TA).

9. The display device of any one of the preceding claims 4-8, wherein at least one of the plurality of trenches (TP) is disposed at at least one location opposite to the one or more line units (LP).

10. The display device of one of the preceding claims, further comprising a trench (TP) disposed in the outer peripheral area, wherein the trench (TP) is disposed at a location opposite to one or more line units (LP), preferably the one or more line units (LP) are configured to transmit one or more signals; and at least a portion of the one or more line units (LP) is disposed in at least a region that is for being transmissive (TA).

11. The display device of one of the preceding claims, wherein in one sub-pixel, the trench is formed as a pattern (TP) and disposed at a position opposite to another sub-pixel adjacent to the one sub-pixel and/or in the one sub-pixel, the trench pattern (TP) is disposed in a position opposite to one of the one or more line units.

12. The display device of one of the preceding claims, wherein trenches or the trench pattern (TP) include one or more concave portions and one or more convex portions.
